# EUROPEAN PATENT SPECIFICATION

(11) **EP 1 576 071 B1**
(45) Date of publication and mention of the grant of the patent: **13.06.2007**
(21) Application number: 03780410.1
(22) Date of filing: 18.12.2003
(51) Int. Cl.: C09K 11/06, H05B 33/08

(54) **ELECTRONIC DEVICES**
ELEKTRONISCHE VORRICHTUNGEN
DISPOSITIFS ELECTRONIQUES

(30) Priority: 20.12.2002 GB 0229659
(43) Date of publication of application: 21.09.2005
(73) Proprietor: Merck Patent GmbH, 64293 Darmstadt (DE)
(72) Inventor: BECKER, Heinrich, 65926 Frankfurt am Main (DE); VESTWEBER, Horst, 65926 Frankfurt am Main (DE); VERES, Janos, Blackley Manchester M9 8ZS (GB); STEIGER, Juergen, 65926 Frankfurt am Main (DE); OGIER, Simon, Dominic, Blackley Manchester M9 8ZS (GB); HEUN, Susane, 65926 Frankfurt am Main (DE); STOESSEL, Philipp, 65926 Frankfurt am Main (DE); GERHARD, Anja, 97209 Veitshöchheim (DE)
(74) Representative: Schüttler, Reinhard
(86) International application number: PCT/GB2003/005523
(87) International publication number: WO 2004/056937

(56) References cited:
- EP-A- 0 827 366
- WO-A-00/78843
- WO-A-99/32537
- US-B1- 6 309 763

## Description

### Field of the Invention

The present invention concerns improvements in and relating to electroluminescent (EL) devices such as Organic Light Emitting Diodes (OLEDs).

### Background of the Invention

OLEDs are optoelectronic devices being developed for use in flat panel displays as alternatives to existing technologies such as the cathode ray tube and liquid crystal displays. OLEDs have the potential to offer numerous advantages including being lightweight and non-bulky, low powered, wide viewing angled, applicable to large display areas and cheaper to manufacture.

An OLED device comprises an organic electroluminescent (EL) layer located between two electrodes. At least one of the electrodes is transparent to allow transmission of light from the EL layer. In operation, when a voltage is applied across the device via the electrodes, holes are injected into one side of the EL layer from one electrode (the anode) and electrons are injected into the other side from the other electrode (the cathode). The holes and electrons move through the EL layer in opposite directions under the applied voltage until they meet and recombine to form an excited state which subsequently decays with the emission of light.

Holes should effectively transfer from the anode into the highest occupied molecular orbital (HOMO) energy level of the EL layer. Similarly, electrons should effectively transfer from the cathode into the lowest unoccupied molecular orbital (LUMO) energy level of the EL layer. Unfortunately, the workfunction of the anode often differs from the HOMO level of the EL layer. The same problem also exists between the cathode and the LUMO level of the EL layer. In practice, since the relevant electronic energy levels of the anode and cathode are often not ideally matched to the highest occupied molecular orbital (HOMO) and lowest unoccupied molecular orbital (LUMO) respectively of the organic EL material, it is usual to modify the basic OLED structure to improve energy level matching and thus improve hole and/or electron injection efficiency. A extensively employed method is to use between the EL layer and the anode and/or cathode respectively an additional organic layer. These additional layers are commonly referred to as a hole injection layer (HIL) and an electron injection layer (EIL). The HIL and/or EIL improve matching of the energy levels, thus improving efficiency of the device. In addition, the HIL and EIL may serve other purposes such as electron blocking and hole blocking respectively (i.e. the HIL or EIL are each one type /one direction carrier transport materials). It has become typical to employ as HIL on the anode a layer of a conducting organic material, such as polyaniline (PAni) or polyethylenedioxythiophene (PEDOT).

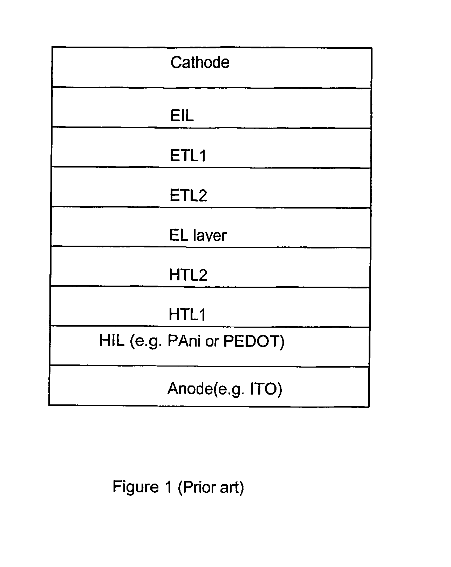

It is not uncommon to find devices employing one or more further organic layers between the HIL and/or EIL respectively and the EL layer to achieve even further enhanced matching of energy levels and thus still higher operating efficiency. The further organic layers between the HIL or EIL and the EL layer are termed hole transport layers (HTLs) and electron transport layers (ETLs) respectively to differentiate them from the HIL or EIL which directly contact the anode or cathode respectively. Such terminology is used herein. A prior art device structure is shown schematically in Figure 1.

Despite the above developments in EL devices which has occurred over recent years, in many aspects there still remains a need for improvement. The present invention is concerned with improvements relating to organic layers in EL devices particularly, but not exclusively, in HILs and HTLs.

In connection with HILs and HTLs, examples of areas where performance could be improved include high efficiency, low drive voltage, transparency, coatability, chemical stability and lifetime. Moreover, present device structures consisting of multiple HIL and HTLs make manufacture complex and costly. It would be desirable to achieve similar or improved performance using a single layer in place of the present multiple layers.

Objects of the invention include reducing or overcoming one or more of the above problems of the prior art. Further objects of the invention will be apparent from the following description.

The invention is based on the finding that certain polyarylamines, in particular polytriarylamines, can offer significant advantages when used in organic layers in EL devices.

### Prior Art

The use of arylamine compounds as HTLs for OLEDs has been disclosed in EP 0 721 935 (Idemitsu Kosan), but polymers of arylamines are not disclosed. Film forming using these small molecule arylamine HTLs is not always satisfactory. Typically, vapour deposition is used for these types of molecules, but such a process is very sensitive to substrate temperature and deposition rate in order to ensure amorphous structure. In addition, the relatively low glass transition temperature (Tg) of small molecule arylamine HTLs leads to instability. Large (e.g. starburst) arylamines (see for example) WO 98/02018 have been developed, partially resolving the issue of Tg, but still require complicated vapour deposition process. Also, such molecules have inferior hole mobility.

The use of polyarylamine materials as HILs or HTLs for OLEDs has been disclosed by Dow Chemical Company, see for instance US 5,728,801, EP 0 827 366 and WO 99/54943. However, the hole mobility and general film forming properties of these particular polyarylamine materials, as well as the general efficiency of devices made therefrom, could be improved upon.

In another Dow patent, US 6,309,763, there are disclosed EL devices in which copolymers of fluorene and arylamine are used in one of the layers. It is also disclosed that the copolymer may be mixed with another polymer which can be an arylamine copolymer. The use of the polyfluorene/arylamine copolymers is in hole transport layers, EL layers, or the blending of different copolymers may achieve transport and luminescent functions in a single layer. However, the document does not suggest the use of 100% arylamine layers.

In general, the prior art uses of polyarylamines fail to solve important issues of device quality, in particular, lifetime and luminescence efficiency.

### Statement of the Invention

According to the present invention there is provided an electroluminescent device having an anode, a cathode and one or more organic layers between said anode and said cathode, at least one of said organic layers comprising an organic electroluminescent material, wherein at least one of said organic layers comprises a polymeric material having repeat units of Formula 1: 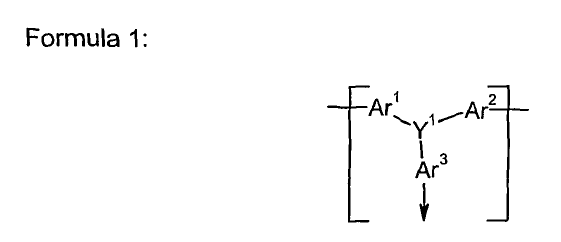 wherein:
Y¹ represents, independently if in different repeat units, N, P, S, As and/or Se, preferably N ;
Ar¹ and Ar² are aromatic groups and Ar³ is present only if Y¹ is N, P, or As in which case it too is an aromatic group; wherein Ar¹ and Ar² are the same or different and represent, independently if in different repeat units, a multivalent (preferably bivalent) aromatic group (preferably mononuclear but optionally polynuclear) optionally substituted by at least one optionally substituted C₁₋₄₀ carbyl-derived groups and/or at least one other optional substituent; and Ar³ represents, independently if in different repeat units, a mono or multivalent (preferably bivalent) aromatic group (preferably mononuclear but optionally polynuclear) optionally substituted by at least one optionally substituted C₁₋₄₀ carbyl-derived group and/or at least one other optional substituent;
and wherein the average number, m, of said repeat units in the polymer is at least 35, preferably at least 40.

In use, when a voltage is applied between the anode and the cathode, holes are injected into the layer adjacent the anode and electrons are injected into the layer adjacent the cathode, whereby light is emitted from the at least one layer comprising the electroluminescent material.

### Detailed Description of the Invention

The EL device is preferably an OLED. At least one of the anode or cathode is transparent. By the term organic layer is meant a layer comprising an organic material.

The device may comprise only one organic layer in which case the organic layer comprising the polymeric material of the invention is the same layer as the layer comprising the EL material. Typically, the device comprises two or more organic layers, wherein the organic layer comprising the polymeric material of the invention is different to the layer comprising the EL material. The at least one organic layer comprising the polymeric material has been found to be excellent for forming a hole injection layer (HIL) and/or hole transport layer (HTL), i.e. separate from the EL layer and located between the EL layer and the anode.

The arrow extending from Ar³ in Formula 1 is intended to indicate that the group may be monovalent or multivalent. If the group is monovalent the arrow denotes a bond to a suitable terminal group such as hydrogen or another substituent which is inert to coupling under the conditions of polymerisation (e.g. alkyl or aryl). If the group is multivalent (e.g. bivalent) the arrow denotes a bond to another repeat unit (i.e. the polymer chain is branched and/or cross-linked).

The polymer may have any chain terminating groups, for example, any leaving groups used in a polymerisation process by which the polymer is made, or end capping groups.

Preferably, the polymer consists essentially of repeat units which have the Formula 1.

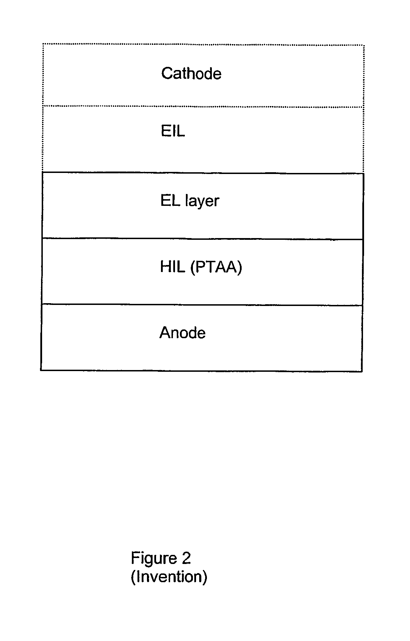

WO 99/32537 is a patent application of the applicants which describes polymers which have repeat units of Formula 1 and methods for their production. In that patent application, polymers of this general type are prepared by the addition of an end capping reagent to control the molecular weight of the final polymer and hence its desirable properties as a charge transport material. As in WO 99/32537, in the present invention, optionally, at least one terminal group is attached in the polymer to the Ar¹, Ar² and optionally Ar³ groups located at the end of the polymer chains, so as to cap the polymer chains and prevent further polymer growth, and at least one terminal group is derived from at least one end capping reagent used in the polymerisation to form said polymeric material to control the molecular weight thereof. However, the disclosure of WO 99/32537 teaches that lower molecular weight polymers (lower m values) are preferred. Specifically, in that document, m values of more than 31 were described as being poor in performance for charge transport layers (see experiment 5 and figure 2 thereof).

WO 00/78843 is another patent application of the applicant which describes polymers which have repeat units of Formula 1. In that patent application, the polymer is prepared by isolating a molecular weight fraction from a starting polymeric material which has repeat units of Formula 1. As with WO 99/32537, the lower molecular weight polymers (lower m values) were exemplified as being the best.

In contrast to the prior art, the present invention has been made in light of the surprising finding that polymeric materials comprising repeat units of Formula 1 having an average number of repeat units, m, of at least 35, preferably at least 40, have better performance in OLEDs.

Examples of preferred polytriarylamines according to the invention are given by formulae 2 and 3:

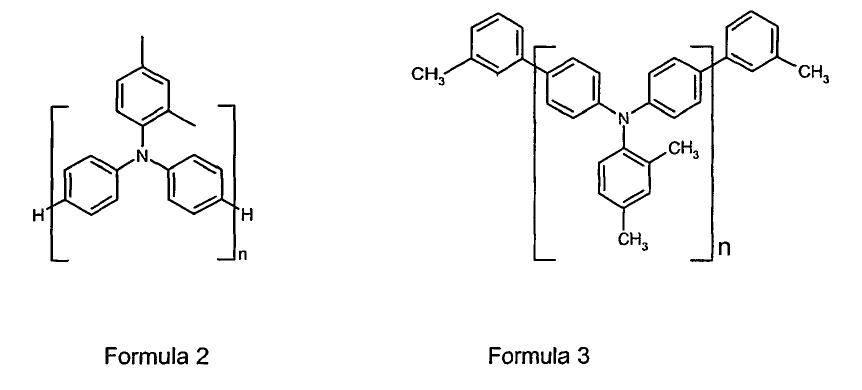

The number of repeat units of Formula 1 which may be present per polymer molecule in the invention (and which can also be denoted by the integer 'n' herein) may be from 2 to 20,000, preferably, 3 to 10,000, more preferably 4 to 5,000, still more preferably, 5 to 500 and most preferably 6 to 100. However, the average number, m, of said repeat units in the polymer is at least 35, preferably at least 40.

The polymeric material with Formula 1 is preferably ring substituted (i.e. substituted on one or more of the Ar¹, Ar² and optionally Ar³ groups) by at least one optionally substituted linear, branched or cyclic carbyl-derived group comprising six or more carbon atoms, i.e. C₆ or higher, preferably an optionally substituted hydrocarbyl, most preferably alkyl or alkoxy, group C₆ or higher. The groups Ar¹, Ar² and Ar³ independently are preferably substituted by the at least one optionally substituted linear, branched or cyclic carbyl-derived group, C₆ or higher, preferably an optionally substituted alkyl or alkoxy group C₆ or higher. This substitution has surprisingly been found to enhance film formation. For example, the material can readily form thick films, which, moreover, are stable and have a long lifetime.

The polymeric material of the invention (i.e. with Formula 1) is preferably polydisperse. Preferably, Mw/Mn is less than 20, more preferably less than 10. Preferably the polydispersity is from 1.1 to 5. More preferably, the polydispersity is from 1.1 to 3.

Advantageously, the polymeric material of the present invention exhibits the following properties: high carrier mobility, compatibility with binders, improved solubility, high durability and/or high resistivity undoped. The polymeric material is highly effective for use in EL devices. It has superior film forming properties, particularly when both the value of m is at least 35 and the polymers are substituted with one or more optionally substituted linear, branched or cyclic carbyl-derived groups (preferably alkyl or alkoxy), C₆ or longer.

The polymeric material of the invention may be used either as a pure polymeric material, or as an admixture of the polymeric material with one or more other polymeric or monomeric materials having different electrical and/or physical properties.

Advantageously, the polymeric material may be easily and cheaply deposited on the device since the material is solution coatable, i.e. it may be readily deposited from solution. Preferably, the polymeric material is applied by a solution coating technique. Preferably, the material is laid down in a film form. The material may be laid down in a film form, which can be optionally patterned or structured, by a variety of coating or printing techniques including, but not limited to, dip coating, roller coating, reverse roll coating, bar coating, spin coating, gravure coating, lithographic coating (including photolithographic processes), ink jet coating (including continuous and drop-on-demand, and fired by piezo or thermal processes), screen coating, spray coating and web coating.

In fabrication of a device according to the invention, other than a so-called "top-emission device" described separately below, the layer comprising the polymeric material of the invention may be solution coated onto the anode or onto a separate HIL provided by known means on the anode, followed by deposition of subsequent layers, including the EL layer, by solution coating or by conventional vapour deposition.

According to another aspect of the invention, there is provided a method of forming the electroluminescent device, which method comprises depositing from a solution the layer comprising the polymeric material. Optionally, the method further comprises depositing at least one other layer, e.g. the EL layer, by vapour deposition or deposition from solution.

As mentioned above, the polymeric material of the present invention has both excellent film forming ability and high mobility. Preferably, the material is applied at high thickness, preferably greater than 40 nm, more preferably greater than 60 nm, still more preferably greater than 100 nm, and most preferably greater than 200 nm, and preferably up to 500 nm, whilst still achieving high yield. Such thick layers have been found to provide numerous advantages, for example, enhanced device lifetime, reproducibility, yield and luminescence. Without being bound by any theory, it is believed that such thick layers improve the device yield by making the structure less sensitive to substrate defects. The thick layer yields particular improvement when the layer is coated directly onto an indium tin oxide (ITO) anode as it is believed that it helps to eliminate the roughness of ITO better than conventional injection layers such as PAni or PEDOT. It has been found that thick layers formed by the polymeric material of the invention improve device lifetime. Again, without being bound by any theory, it is believed that this is also due to reducing the effects of surface defects. In particular, the thick layer may reduce shorting effects and local spots at the electrode, thereby increasing the lifetime of the EL layer. The material has been found to be particularly useful in this regard for blue emitting EL materials.

The polymeric material preferably has a hole mobility greater than 10⁻³ cm²V⁻¹s⁻¹, which is an enabling factor in the fabrication of such thick layers. The high mobility of the polymeric material used in the present invention also enables the drive voltage to be kept relatively low for high luminescent efficiencies. The high hole mobility of the polymeric material of the invention means that the potential drop across the layer comprising the material can be very small. Conventional PAni or PEDOT injection layers have low conductivity to avoid "crosstalk" between neighbouring pixels in display devices. However, a thick layer of the polymeric material of the invention can effectively perform this function due to its unipolar nature.

The polymeric material of the invention advantageously also enables a high quality ohmic interface between the material and the anode, e.g., an ITO anode. This in turn yields improvements in device lifetime since non-ohmic contact is thought in part to be responsible for hot spots due to localised build up of electric field at the anode resulting in break down of the adjacent injection layer. It has not previously been easy to find appropriate hole transport materials that allow for an ohmic contact. It has previously been tried to employ doped transport layers. However, this such doping is difficult to implement in a real manufacturing process and attractive lifetime has not yet been demonstrated.

ITO is a highly preferred anode material due to its transparency, high conductivity and availability on glass or polymer substrates. ITO has a workfunction between 4.8-5 eV. In a preferred embodiment, the polymeric material has an ionisation potential close to this value, for example 4.8-5.2 eV. Thus, holes can be injected into the organic layer comprising the polymeric material unhindered.

Conventionally, materials such as PAni or PEDOT are used for the role of the HIL. A separate HTL is typically employed between the PAni or PEDOT layer and the EL layer. We have found that the polymeric material of the invention can effectively perform both the injection function of the PAni or PEDOT and the role of the separate HTL due to its matching ionisation potential and excellent surface levelling ability when coated in a thick layer, e.g. from a solution. Thus, in one advantageous embodiment, the invention provides a HIL comprising the polymeric material, i.e. without need for, e.g., PAni or PEDOT. In a further advantageous embodiment, the invention provides an EL device in which there is only one organic layer between the anode and the (organic) EL layer as shown in Figure 2. This single organic layer (HIL) comprising the polymeric material between the anode and the EL layer greatly simplifies the device and processing thereof compared with the prior art device structure shown in Figure 1. In addition, there is no loss of efficiency; indeed, efficiency in many cases is improved. This solves the problem in the prior art of needing multiple organic layers (HIL, HTLs etc.).

It will be appreciated that other embodiments may exist wherein, if desired, the polymeric material of the invention may be used with a separate HIL, e.g. comprising PAni or PEDOT, whilst still providing benefits. Thus, in another embodiment, the invention provides a HTL comprising the polymeric material.

In another embodiment, there may be a HIL comprising the polymeric material of the invention and, in addition, one or more HTL(s) comprising the polymeric material of the invention, the polymeric material in each of the HIL and HTL(s) being independently optimised in terms of its ionisation potential, e.g., for matching to the anode and EL layer respectively.

A composition comprising a blend of two or more different polymeric materials according to the invention may be used.

The polymeric material of the invention, when used in place of certain conventional EL device materials, e.g. PAni or PEDOT, can yield improvements in transparency and colour rendition, especially with blue emitting EL devices. This is due to the polymeric material being substantially transparent or "white". The polymeric material is also substantially, preferably totally, amorphous, in contrast to a conventional material such as PAni.

It has been found that the polymeric material of the invention is better at blocking electrons than conventional materials, e.g. PAni or PEDOT, thus leading to improvements in device efficiency.

The polymeric material of the invention has been found to be more chemically stable than conventional HIL material such as PAni or PEDOT. Conventional PAni and PEDOT materials for example are acid doped and possess counter-ions which, with time, migrate into adjacent layers and cause a deterioration in device performance. The polymeric material of the invention, however, does not need counter-ions, thus eliminating the problem. This is particularly advantageously for triple emitting devices

The polymeric materials of the invention have a relatively high glass transition temperature (T_{g}), which leads to improved stability.

The polymeric material may be used in conjunction with a binder resin to further improve film formation and/or adjust viscosity for improving solution coatability. The binder may also be optionally crosslinked for improved stack integrity of layers as described in more detail below. A binder is preferred for an EL device wherein all of the organic layers are solution coated.

Preferred binders are electrical insulators. Preferred binders include, without limitation, at least one of polyamide, polyurethane, polyether, polyester, epoxy resin, polyketone, polycarbonate, polysulphone, vinyl polymer (for example polyvinylketone and/or polyvinylbutyral), polystyrene, polyacrylamide, copolymers thereof (such as aromatic copolymeric polycarbonate polyesters) and/or mixtures thereof.

Those binders disclosed in the patent application WO 99/32537 of the applicant, particularly at pages 24 and 25 of that application as published, are useful for the present invention and that disclosure is incorporated herein by reference. In addition, those binders claimed in and described in the patent application WO 02/45184 of the applicant, particularly at pages 3, 4, 8-11 of that application as published, including those listed in Tables 1 and 2 therein, are useful for the present invention and that disclosure is also incorporated herein by reference

To improve stack integrity between the layer comprising the polymeric material and adjacent layers, the layer comprising the polymeric material optionally may be crosslinked. The crosslinking may be achieved by crosslinking of the polymeric material, e.g. by means of a crosslinkable functionality in the polymer, and/or by crosslinking of the binder resin where present, for example as disclosed in WO 02/45184.

Advantageously, the polymeric material of the invention provides routes to novel device structures by enabling depositing of the transparent electrode on top of an OLED stack for a 'top emission device' preferred in some active matrix display configurations for increased luminance and resolution. It is very desirable for the deposition of the transparent top electrode to use fast processes such as sputtering. For example for depositing ITO. However, these processes are likely to damage the vulnerable active organic layers due to the high kinetic energy of the particles deposited. A thick hole transport layer for example, formed by the polymeric material of the invention, provides protection and thus allows for a robust and commercially viable manufacturing process (high yield) without affecting the device performance (efficiency, driving voltage, lifetime).

The definitions of various terms used herein will now be explained.

In any of the polymeric formulae given herein, the polymer may have any terminal or end capping groups, including hydrogen.

When in the formulae herein there is a list of labels (e.g. Ar¹ Ar² and Ar³) or indices (e.g. 'n') which are said to represent a list of groups or numerical values, and these are said to be "independent in each case" this indicates each label and/or index can represent any of those groups listed independently from each other, independently within each repeat unit, independently within each Formula and/or independently on each group which is substituted as appropriate. Thus, in each of these instances, many different groups might be represented by a single label (e.g. Ar¹).

The terms 'optional substituent' and/or 'optionally substituted' as used herein (unless followed by a list of other substituents) signifies, for example, at least one of the following groups (or substitution by these groups): sulpho, sulphonyl, formyl, amino, imino, nitrilo, mercapto, cyano, nitro, halo, C₁₋₄alkyl, C₁₋₄alkoxy, hydroxy and/or combinations thereof. These optional groups may comprise all chemically possible combinations in the same group and/or a plurality (preferably two) of the aforementioned groups (e.g. amino and sulphonyl if directly attached to each other represent a sulphamoyl radical). Preferred optional substituents comprise: any of C₁₋₄alkyl, methoxy and/or ethoxy (any of these optionally substituted by at least one halo); and/or amino (optionally substituted by at least one methyl and/or ethyl); and/or halo. The term 'halo' as used herein signifies fluoro, chloro, bromo and iodo. The term 'carbyl-derived' as used herein denotes any monovalent or multivalent organic radical moiety which comprises at least one carbon atom either without any non-carbon atoms (e.g. -C≡C-), or optionally combined with at least one other non-carbon atom (e.g. alkoxy, carbonyl etc.). The non-carbon atom(s) may comprise any elements other than carbon (including any chemically possible mixtures or combinations thereof) that together with carbon can comprise an organic radical moiety. Preferably the non-carbon atom is selected from at least one hydrogen and/or heteroatom, more preferably from at least one: hydrogen, phosphorus, halo, nitrogen, oxygen and/or sulphur, most preferably from at least one hydrogen, nitrogen, oxygen and/or sulphur. Carbyl-derived groups include all chemically possible combinations in the same group of a plurality (preferably two) of the aforementioned carbon and/or non-carbon atom containing moieties (e.g. alkoxy and carbonyl if directly attached to each other represent an alkoxycarbonyl radical).

The term 'hydrocarbyl' as used herein denotes any radical moiety which comprises at least one hydrogen atom and at least one carbon atom. A hydrocarbyl group may however be optionally substituted. Preferably, 'hydrocarbyl' groups comprise at least one of the following carbon containing moieties: alkyl, alkoxy, alkanoyl, carboxy, carbonyl, formyl and/or combinations thereof; optionally in combination with at least one of the following heteroatom containing moieties: oxy, thio, sulphinyl, sulphonyl, amino, imino, nitrilo and/or combinations thereof. More preferred hydrocarbyl groups comprise at least one: alkyl and/or alkoxy (optionally substituted with at least one halo).

The term 'alkyl' as used herein may be readily replaced, where appropriate, by terms denoting a different degree of saturation and/or valence e.g. moieties that comprise double bonds, triple bonds, and/or aromatic moieties (e.g. alkenyl, alkynyl and/or aryl) as well as multivalent species attached to two or more substituents (such as alkylene).

Unless the context clearly indicates otherwise, a group herein which comprises a chain of three or more atoms signifies a group in which the chain wholly or in part may be linear, branched and/or form a ring (including spiro and/or fused rings).

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

## Claims

1. An electroluminescent device having an anode and a cathode, one of which is transparent, and one or more organic layers between said anode and said cathode, at least one of said organic layers comprising an organic electroluminescent material, wherein at least one of said organic layers comprises a polymeric material having repeat units of Formula 1: 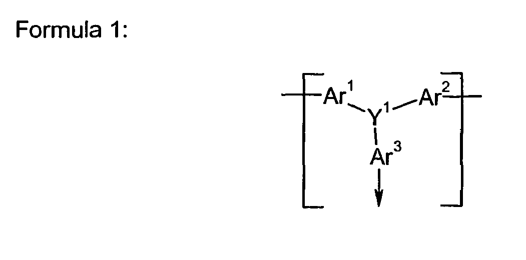 wherein:
Y¹ represents, independently if in different repeat units, N, P, S, As and/or Se, preferably N ;
Ar¹ and Ar² are aromatic groups and Ar³ is present only if Y¹ is N, P, or As in which case it too is an aromatic group; wherein Ar¹ and Ar² are the same or different and represent, independently if in different repeat units, a multivalent (preferably bivalent) aromatic group (preferably mononuclear but optionally polynuclear) optionally substituted by at least one optionally substituted C₁₋₄₀ carbyl-derived groups and/or at least one other optional substituent; and Ar³ represents, independently if in different repeat units, a mono or multivalent (preferably bivalent) aromatic group (preferably mononuclear but optionally polynuclear) optionally substituted by at least one optionally substituted C₁₋₄₀ carbyl-derived group and/or at least one other optional substituent, and wherein the average number, m, of said repeat units in the polymer is at least 35

2. An electroluminescent device as claimed in claim 1
wherein the average number, m, of said repeat units in the polymer is at least 40.

3. An electroluminescent device as claimed in claim 1 or 2 wherein the polymeric material is ring substituted by at least one optionally substituted linear, branched or cyclic carbyl-derived group, which is C₆ or higher,

4. An electroluminescent device as claimed in claim 3 wherein the at least one optionally substituted linear, branched or cyclic carbyl-derived group comprises an alkyl or alkoxy group.

5. An electroluminescent device as claimed in any one of the preceding claims wherein the polymeric material is polydisperse.

6. An electroluminescent device as claimed in any one of the preceding claims wherein the device comprises only one organic layer such that the organic layer comprising the polymeric material is the same layer as the layer comprising the electroluminescent material.

7. An electroluminescent device as claimed in any one of claims 1 to 5 wherein the device comprises two or more organic layers, the at least one organic layer comprising the polymeric material being separate from the at least one organic layer comprising the electroluminescent material and being located between the layer comprising the electroluminescent material and the anode.

8. An electroluminescent device as claimed in any one of the preceding claims wherein the polymeric material is used as an admixture of the polymeric material with one or more other polymeric or monomeric materials having different electrical and/or physical properties.

9. An electroluminescent device as claimed in claim 8 wherein the admixture comprises a blend of two or more of the polymeric materials claimed in claim 1.

10. An electroluminescent device as claimed in any one of the preceding claims wherein the polymeric material has been deposited from solution.

11. An electroluminescent device as claimed in any one of the preceding claims wherein the polymeric material has been applied by a coating or printing technique selected from the following group: dip coating, roller coating, reverse roll coating, bar coating, spin coating, gravure coating, lithographic coating (including photolithographic processes), ink jet coating (including continuous and drop-on-demand, and fired by piezo or thermal processes), screen coating, spray coating and web coating.

12. An electroluminescent device as claimed in any one of the preceding claims wherein the thickness of the layer comprising the polymeric material is greater than 40 nm.

13. An electroluminescent device as claimed in claim 12 wherein the thickness of the layer comprising the polymeric material is greater than 60 nm.

14. An electroluminescent device as claimed in claim 13 wherein the thickness of the layer comprising the polymeric material is greater than 100 nm.

15. An electroluminescent device as claimed in claim 14 wherein the thickness of the layer comprising the polymeric material is greater than 200 nm.

16. An electroluminescent device as claimed in any one of claims 12 to 15 wherein the thickness of the layer comprising the polymeric material is up to 500 nm.

17. An electroluminescent device as claimed in any one of the preceding claims wherein the polymeric material has a hole mobility greater than 10⁻³ cm²V⁻¹s⁻¹.

18. An electroluminescent device as claimed in any one of the preceding claims wherein the polymeric material forms an ohmic interface with the anode.

19. An electroluminescent device as claimed in any one of the preceding claims wherein the anode comprises an oxide of indium and tin (ITO)

20. An electroluminescent device as claimed in claim 19 wherein the polymeric material has an ionisation potential in the range 4.8 - 5.2 eV.

21. An electroluminescent device as claimed in any one of the preceding claims wherein the layer comprising the polymeric material is in direct contact with the anode.

22. An electroluminescent device as claimed in claim 21 wherein the layer comprising the polymeric material is the only organic layer between the anode and the layer comprising the electroluminescent material.

23. An electroluminescent device as claimed in any one of the preceding claims wherein the polymeric material is mixed in a binder resin.

24. An electroluminescent device as claimed in any one of the preceding claims wherein the binder resin is selected from the group: polyamide, polyurethane, polyether, polyester, epoxy resin, polyketone, polycarbonate, polysulphone, vinyl polymer, polystyrene, polyacrylamide, copolymers thereof and/or mixtures thereof.

25. An electroluminescent device as claimed in any one of the preceding claims wherein the layer comprising the polymeric material is crosslinked.

26. An electroluminescent device as claimed in claim 25 wherein the layer is crosslinked by crosslinking of the polymeric material and/or by crosslinking of the binder resin.

27. An electroluminescent device as claimed in any one of the preceding claims wherein the electroluminescent material, in use, emits blue light.

28. An electroluminescent device as claimed in any one of the preceding claims which is a top emission device wherein the transparent electrode is deposited after the layer comprising the polymeric material.

29. A method of forming an electroluminescent device as claimed in any one of the preceding claims comprising depositing from a solution the layer comprising the polymeric material.

30. A method of forming an electroluminescent device as claimed in claim 29 further comprising depositing at least one other layer by vapour deposition.

## Patentansprüche

1. Elektrolumineszenzvorrichtung mit einer Anode und einer Kathode, von denen eine transparent ist, und einer oder mehreren organischen Schichten zwischen der Anode und der Kathode, wobei mindestens eine der organischen Schichten ein organisches Elektrolumineszenzmaterial enthält, worin mindestens eine der organischen Schichten ein Polymermaterial mit wiederkehrenden Einheiten der Formel 1: 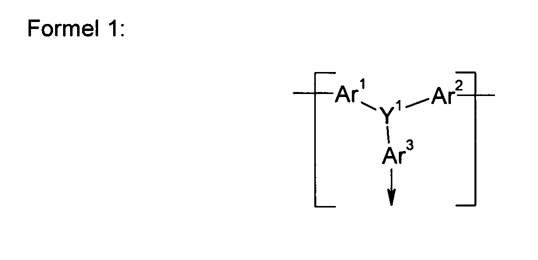 enthält, worin:
Y¹, bei Auftreten in verschiedenen wiederkehrenden Einheiten unabhängig, N, P, S, As und/oder Se, vorzugsweise N darstellt;
Ar¹ und Ar² aromatische Gruppen bedeuten und Ar³ nur vorhanden ist, wenn Y¹ für N, P oder As steht, und in diesem Falle ebenfalls eine aromatische Gruppe bedeutet; worin Ar¹ und Ar² gleich oder verschieden sind und, bei Auftreten in verschiedenen wiederkehrenden Einheiten unabhängig, eine mehrwertige (vorzugsweise zweiwertige) aromatische (vorzugsweise einkernige, aber gegebenenfalls mehrkernige) Gruppe darstellen, die gegebenenfalls durch mindestens eine gegebenenfalls substituierte, von C₁₋₄₀-Carbyl abgeleitete Gruppe und/oder mindestens einen anderen möglichen Substituenten substituiert ist; und Ar³, bei Auftreten in verschiedenen wiederkehrenden Einheiten unabhängig, eine ein- oder mehrwertige (vorzugsweise zweiwertige) aromatische (vorzugsweise einkernige, aber gegebenenfalls mehrkernige) Gruppe darstellt, die gegebenenfalls durch mindestens eine gegebenenfalls substituierte, von C₁₋₄₀-Carbyl abgeleitete Gruppe und/oder mindestens einen anderen möglichen Substituenten substituiert ist, und worin die durchschnittliche Anzahl, m, der wiederkehrenden Einheiten im Polymer mindestens 35 beträgt.

2. Elektrolumineszenzvorrichtung nach Anspruch 1, worin die durchschnittliche Anzahl, m, der wiederkehrenden Einheiten im Polymer mindestens 40 beträgt.

3. Elektrolumineszenzvorrichtung nach Anspruch 1 oder 2, worin das Polymermaterial durch mindestens eine gegebenenfalls substituierte lineare, verzweigte oder cyclische von Carbyl abgeleitete Gruppe, die C₆ oder höher ist, ringsubstituiert ist.

4. Elektrolumineszenzvorrichtung nach Anspruch 3, worin die mindestens eine gegebenenfalls substituierte lineare, verzweigte oder cyclische von Carbyl abgeleitete Gruppe eine Alkyl- oder Alkoxygruppe enthält.

5. Elektrolumineszenzvorrichtung nach einem der vorhergehenden Ansprüche, worin das Polymermaterial polydispers ist.

6. Elektrolumineszenzvorrichtung nach einem der vorhergehenden Ansprüche, worin die Vorrichtung nur eine organische Schicht enthält, so dass die das Polymermaterial enthaltende organische Schicht dieselbe Schicht wie die das Elektrolumineszenzmaterial enthaltende Schicht ist.

7. Elektrolumineszenzvorrichtung nach einem der Ansprüche 1 bis 5, worin die Vorrichtung zwei oder mehr organische Schichten enthält, wobei die mindestens eine das Polymermaterial enthaltende organische Schicht von der mindestens einen das Elektrolumineszenzmaterial enthaltenden organischen Schicht getrennt ist und zwischen der das Elektrolumineszenzmaterial enthaltenden Schicht und der Anode angeordnet ist.

8. Elektrolumineszenzvorrichtung nach einem der vorhergehenden Ansprüche, worin das Polymermaterial als Gemisch des Polymermaterials mit einem oder mehreren anderen Polymer- oder Monomermaterialien mit unterschiedlichen elektrischen und/oder physikalischen Eigenschaften verwendet wird.

9. Elektrolumineszenzvorrichtung nach Anspruch 8, worin das Gemisch eine Mischung aus zwei oder mehr der Polymermaterialien nach Anspruch 1 enthält.

10. Elektrolumineszenzvorrichtung nach einem der vorhergehenden Ansprüche, worin das Polymermaterial aus der Lösung abgeschieden wurde.

11. Elektrolumineszenzvorrichtung nach einem der vorhergehenden Ansprüche, worin das Polymermaterial mit einer Beschichtungs- oder Drucktechnik ausgewählt aus der folgenden Gruppe aufgetragen wurde: Tauchbeschichtung, Walzenbeschichtung, Umkehrwalzenbeschichtung, Stabbeschichtung, Spincoating, Tiefdruckbeschichtung, lithographische Beschichtung (einschließlich photolithographischer Verfahren), Tintenstrahlbeschichtung (einschließlich kontinuierlicher und Drop-on-demand-Verfahren, und mit Piezo- oder thermischer Auslösung), Siebdruckbeschichtung, Sprühbeschichtung und Rollenbeschichtung.

12. Elektrolumineszenzvorrichtung nach einem der vorhergehenden Ansprüche, worin die Dicke der das Polymermaterial enthaltenden Schicht mehr als 40 nm beträgt.

13. Elektrolumineszenzvorrichtung nach Anspruch 12, worin die Dicke der das Polymermaterial enthaltenden Schicht mehr als 60 nm beträgt.

14. Elektrolumineszenzvorrichtung nach Anspruch 13, worin die Dicke der das Polymermaterial enthaltenden Schicht mehr als 100 nm beträgt.

15. Elektrolumineszenzvorrichtung nach Anspruch 14, worin die Dicke der das Polymermaterial enthaltenden Schicht mehr als 200 nm beträgt.

16. Elektrolumineszenzvorrichtung nach einem der Ansprüche 12 bis 15, worin die Dicke der das Polymermaterial enthaltenden Schicht bis zu 500 nm beträgt.

17. Elektrolumineszenzvorrichtung nach einem der vorhergehenden Ansprüche, worin das Polymermaterial eine Lochmobilität von mehr als 10⁻³ cm²V⁻¹s⁻¹ besitzt.

18. Elektrolumineszenzvorrichtung nach einem der vorhergehenden Ansprüche, worin das Polymermaterial eine ohmsche Grenzfläche mit der Anode bildet.

19. Elektrolumineszenzvorrichtung nach einem der vorhergehenden Ansprüche, worin die Anode ein Oxid von Indium und Zinn (ITO) enthält.

20. Elektrolumineszenzvorrichtung nach Anspruch 19, worin das Polymermaterial has an lonisationspotential im Bereich von 4.8 - 5.2 eV besitzt.

21. Elektrolumineszenzvorrichtung nach einem der vorhergehenden Ansprüche, worin sich die das Polymermaterial enthaltende Schicht in direktem Kontakt mit der Anode befindet.

22. Elektrolumineszenzvorrichtung nach Anspruch 21, worin die das Polymermaterial enthaltende Schicht die einzige organische Schicht zwischen der Anode und der das Elektrolumineszenzmaterial enthaltenden Schicht ist.

23. Elektrolumineszenzvorrichtung nach einem der vorhergehenden Ansprüche, worin das Polymermaterial in ein Bindemittelharz eingemischt ist.

24. Elektrolumineszenzvorrichtung nach einem der vorhergehenden Ansprüche, worin das Bindemittelharz aus der Gruppe: Polyamid, Polyurethan, Polyether, Polyester, Epoxyharz, Polyketon, Polycarbonat, Polysulfon, Vinylpolymer, Polystyrol, Polyacrylamid, deren Copolymeren und/oder deren Mischungen ausgewählt ist.

25. Elektrolumineszenzvorrichtung nach einem der vorhergehenden Ansprüche, worin die das Polymermaterial enthaltende Schicht vernetzt ist.

26. Elektrolumineszenzvorrichtung nach Anspruch 25, worin die Schicht durch Vernetzen des Polymermaterials und/oder durch Vernetzen des Bindemittelharzes vernetzt ist.

27. Elektrolumineszenzvorrichtung nach einem der vorhergehenden Ansprüche, worin das Elektrolumineszenzmaterial bei der Verwendung blaues Licht emittiert.

28. Elektrolumineszenzvorrichtung nach einem der vorhergehenden Ansprüche, wobei es sich um eine Oberseitenemissionsvorrichtung handelt, worin die transparente Elektrode nach der das Polymermaterial enthaltenden Schicht abgeschieden wird.

29. Verfahren zur Bildung einer Elektrolumineszenzvorrichtung nach einem der vorhergehenden Ansprüche, umfassend das Abscheiden der das Polymermaterial enthaltenden Schicht aus einer Lösung.

30. Verfahren zur Bildung einer Elektrolumineszenzvorrichtung nach Anspruch 29, weiterhin umfassend das Abscheiden mindestens einer anderen Schicht durch Vakuumbedampfen.

## Revendications

1. Dispositif électroluminescent comportant une anode et une cathode, dont l'une est transparente, et une ou plusieurs couches organiques entre ladite anode et ladite cathode, au moins l'une desdites couches organiques comprenant un matériau électroluminescent organique, dans lequel au moins l'une desdites couches organiques comprend un matériau polymérique comportant des unités de répétition de la Formule 1: 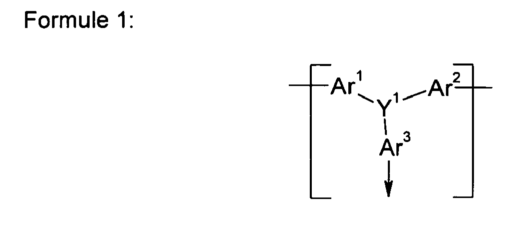 dans laquelle:
Y¹ représente, indépendamment de si dans des unités de répétition différentes, N, P, S, As et/ou Se, de préférence N ;
Ar¹ et Ar² sont des groupes aromatiques et Ar³ est présent seulement si Y¹ est N, P, ou As, auquel cas il est aussi un groupe aromatique; où Ar¹ et Ar² sont les mêmes ou sont différents et représentent, indépendamment de si dans des unités de répétition différentes, un groupe aromatique multivalent (de préférence bivalent) (de préférence mononucléaire mais en option polynucléaire) en option substitué par au moins l'un de groupes dérivés de carbyle en option substitué(s) en C₁₋₄₀ et/ou par au moins un autre substituent optionnel; et Ar³ représente, indépendamment de si dans des unités de répétition différentes, un groupe aromatique (de préférence mononucléaire mais en option polynucléaire) mono- ou multivalent (de préférence bivalent) en option substitué par au moins un groupe dérivé de carbyle en option substitué en C₁₋₄₀ et/ou par au moins un autre substituent optionnel, et où le nombre moyen, m, desdites unités de répétition dans le polymère est d'au moins 35.

2. Dispositif électroluminescent selon la revendication 1, dans lequel le nombre moyen, m, desdites unités de répétition dans le polymère est d'au moins 40.

3. Dispositif électroluminescent selon la revendication 1 ou 2, dans lequel le matériau polymérique est un cycle substitué par au moins un groupe dérivé de carbyle linéaire, ramifié ou cyclique en option substitué, qui est C₆ ou plus.

4. Dispositif électroluminescent selon la revendication 3, dans lequel l'au moins un groupe dérivé de carbyle linéaire, ramifié ou cyclique en option substitué comprend un groupe alkyle ou alcoxy.

5. Dispositif électroluminescent selon l'une quelconque des revendications précédentes, dans lequel le matériau polymérique est polydispersé.

6. Dispositif électroluminescent selon l'une quelconque des revendications précédentes, dans lequel le dispositif comprend seulement une couche organique de telle sorte que la couche organique comprenant le matériau polymérique est la même couche que la couche comprenant le matériau électroluminescent.

7. Dispositif électroluminescent selon l'une quelconque des revendications 1 à 5, dans lequel le dispositif comprend deux couches organiques ou plus, l'au moins une couche organique comprenant le matériau polymérique étant séparée de l'au moins une couche organique comprenant le matériau électroluminescent et étant localisée entre la couche comprenant le matériau électroluminescent et l'anode.

8. Dispositif électroluminescent selon l'une quelconque des revendications précédentes, dans lequel le matériau polymérique est utilisé en tant qu'ajout du matériau polymérique avec un ou plusieurs autres matériaux polymériques ou monomériques présentant des propriétés électriques et/ou physiques différentes.

9. Dispositif électroluminescent selon la revendication 8, dans lequel l'ajout comprend un mélange de deux des matériaux polymériques ou plus revendiqués selon la revendication 1.

10. Dispositif électroluminescent selon l'une quelconque des revendications précédentes, dans lequel le matériau polymérique a été déposé à partir d'une solution.

11. Dispositif électroluminescent selon l'une quelconque des revendications précédentes, dans lequel le matériau polymérique a été appliqué au moyen d'une technique de revêtement ou d'impression choisie à partir du groupe qui suit: revêtement par immersion, revêtement par rouleau, revêtement par rouleau inverse, revêtement par barre, revêtement par centrifugation, revêtement par gravure, revêtement lithographique (y compris des processus photolithographiques), revêtement par jet d'encre (y compris des processus continus et par gouttes à la demande, et amorcés par processus piézo ou thermique), revêtement par sérigraphie, revêtement par pulvérisation et revêtement par bande.

12. Dispositif électroluminescent selon l'une quelconque des revendications précédentes, dans lequel l'épaisseur de la couche comprenant le matériau polymérique est supérieure à 40 nm.

13. Dispositif électroluminescent selon la revendication 12, dans lequel l'épaisseur de la couche comprenant le matériau polymérique est supérieure à 60 nm.

14. Dispositif électroluminescent selon la revendication 13, dans lequel l'épaisseur de la couche comprenant le matériau polymérique est supérieure à 100 nm.

15. Dispositif électroluminescent selon la revendication 14, dans lequel l'épaisseur de la couche comprenant le matériau polymérique est supérieure à 200 nm.

16. Dispositif électroluminescent selon l'une quelconque des revendications 12 à 15, dans lequel l'épaisseur de la couche comprenant le matériau polymérique va jusqu'à 500 nm.

17. Dispositif électroluminescent selon l'une quelconque des revendications précédentes, dans lequel le matériau polymérique présente une mobilité de trous supérieure à 10⁻³ cm²V⁻¹s⁻¹.

18. Dispositif électroluminescent selon l'une quelconque des revendications précédentes, dans lequel le matériau polymérique forme une interface ohmique avec l'anode.

19. Dispositif électroluminescent selon l'une quelconque des revendications précédentes, dans lequel l'anode comprend un oxyde d'indium et d'étain (ITO).

20. Dispositif électroluminescent selon la revendication 19, dans lequel le matériau polymérique présente un potentiel d'ionisation dans la plage de 4,8 - 5,2 eV.

21. Dispositif électroluminescent selon l'une quelconque des revendications précédentes, dans lequel la couche comprenant le matériau polymérique est en contact direct avec l'anode.

22. Dispositif électroluminescent selon la revendication 21, dans lequel la couche comprenant le matériau polymérique est la seule couche organique entre l'anode et la couche comprenant le matériau électroluminescent.

23. Dispositif électroluminescent selon l'une quelconque des revendications précédentes, dans lequel le matériau polymérique est mélangé dans une résine de liant.

24. Dispositif électroluminescent selon l'une quelconque des revendications précédentes, dans lequel la résine de liant est choisie parmi le groupe: polyamide, polyuréthane, polyéther, polyester, résine époxy, polycétone, polycarbonate, polysulphone, polymère de vinyle, polystyrène, polyacrylamide, des copolymères afférents et/ou des mélanges afférents.

25. Dispositif électroluminescent selon l'une quelconque des revendications précédentes, dans lequel la couche comprenant le matériau polymérique est réticulée.

26. Dispositif électroluminescent selon la revendication 25, dans lequel la couche est réticulée par réticulation du matériau polymérique et/ou par réticulation de la résine de liant.

27. Dispositif électroluminescent selon l'une quelconque des revendications précédentes, dans lequel le matériau électroluminescent, en utilisation, émet une lumière bleue.

28. Dispositif électroluminescent selon l'une quelconque des revendications précédentes, qui est un dispositif d'émission sommitale dans lequel l'électrode transparente est déposée après la couche comprenant le matériau polymérique.

29. Procédé de formation d'un dispositif électroluminescent selon l'une quelconque des revendications précédentes, comprenant le dépôt à partir d'une solution de la couche comprenant le matériau polymérique.

30. Procédé de formation d'un dispositif électroluminescent selon la revendication 29, comprenant en outre le dépôt d'au moins une autre couche par dépôt en phase vapeur.
